# EUROPÄISCHE PATENTSCHRIFT

(11) **EP 2 711 726 B1**
(45) Veröffentlichungstag und Bekanntmachung des Hinweises auf die Patenterteilung: **05.11.2014**
(21) Anmeldenummer: 12185021.8
(22) Anmeldetag: 19.09.2012
(51) Int. Cl.: G01R 31/36, H01M 10/48

(54) **Vorrichtung zur Spannungsüberwachung**
Device for voltage monitoring
Dispositif de surveillance de tension

(43) Veröffentlichungstag der Anmeldung: 26.03.2014
(73) Patentinhaber: MAGNA STEYR Battery Systems GmbH & Co OG, 8141 Zettling (AT)
(72) Erfinder: Stark, Johann, 8302 Nestelbach/Graz (AT)
(74) Vertreter: Rausch, Gabriele

(56) Entgegenhaltungen:
- EP-A2- 2 530 777
- WO-A1-2012/085562
- AT-U1- 9 790
- US-A1- 2005 110 458

## Beschreibung

### Gebiet der Erfindung

Die vorliegende Erfindung betrifft eine Vorrichtung zur Spannungsüberwachung von Batteriezellen, insbesondere eine Vorrichtung zur Spannungsüberwachung von Batteriezellen umfassend ein Steuergerät, Spannungsabgriffe zum Abgriff der Spannungen der Batteriezellen und Messleitungen zur elektrischen Verbindung des Steuergeräts mit den Spannungsabgriffen, wobei die Messleitungen durch ein Stanzgitter gebildet sind.

Insbesondere Hochvolt-Batteriesysteme die aus einer Vielzahl von beispielsweise Li-Ion-Zellen aufgebaut sind, verfügen üblicherweise über eine Überwachung der Spannung der einzelnen Batteriezellen und bevorzugt auch eine Einrichtung zum Abgleich der Spannungen der Batteriezellen untereinander ("Load-Balancing"). Der Abgriff der Zellspannungen erfolgt entweder direkt an Zellpolen oder auch an Zellverbindern.

### Stand der Technik

Aus der DE 198 47 190 A1 ist beispielsweise eine Verbindungsplatte für einen Batteriehalter bekannt, die als gespritzte Harzplatte ausgeführt ist, mit eingegossenen Stromschienen und mit Spannungsmessanschlüssen und Drähten für das Messen der Spannungen von Batterien. Durch das Eingießen ist die Lage der Stromschienen festgelegt. Die Drähte werden aus der Verbindungsplatte herausgeführt und können zu einer zu verbindenden ECU (Electronic Control Unit) führen.

Weiters ist es aus der US 2011/0045329 A1 bekannt, Anschlussstücke zu verwenden, wobei jeweils ein Ende eines Anschlussstückes mit einer Stromschiene verbindbar ist und das zweite Ende über Scherenabschnitte mit einem Draht verbindbar ist, wobei die Drähte wiederum mit einem Spannungsmessgerät verbindbar sind.

Aus der DE 10 2009 050 315 A1 ist eine Verbindungsvorrichtung bekannt zum elektrisch leitenden Verbinden mehrerer Zellterminals von Zellen. Die Vorrichtung weist Leiterbahnen auf, die einstückig mit Zellverbindern verbunden sind. Die einstückig miteinander verbundenen Zellverbinder bilden eine Verbinder-Baugruppe, welche als Einheit gehandhabt und den miteinander zu verbindenden elektrochemischen Zellen als Einheit zugeführt werden kann. Verbindungsstege, welche die Zellverbinder der Verbinder-Baugruppe miteinander verbinden, können nach dem Festlegen der Zellverbinder an den jeweils miteinander zu verbindenden Zellterminals entfernt werden. Die Zellverbinder sind an einem Hilfsrahmen gehalten, der auch die Leiterbahnen abstützt. Die den Zellverbindern abgewandten freien Enden der Leiterbahnen sind elektrisch leitend mit einem Verbindungssteg verbunden, welcher durch einen Stecker einer Kabelverbindung ersetzbar ist, die zu einer Steuereinheit führt.

WO 2012/085562 A1, AT 009 790 U1, US 2005/110458 A1 und EP 2530 777 A2 (nach Art. 54(3) EPÜ) offenbaren verschiedene Verbindereinheiten für die Überwachung von Batteriezellen.

Nachteilig ist an den bekannten Lösungen, dass deren Herstellung kompliziert und kostspielig ist, beispielsweise weil die prozesssichere Herstellung nachträglicher Verbindungen zwischen Zellverbindern und Messleitungen erforderlich ist und/oder weil die Handhabung von Elementen wie Leiterbahnen oder Zellverbindern mit ungenau festgelegter Lage erforderlich ist.

### Zusammenfassung der Erfindung

Es ist eine Aufgabe der Erfindung, Vorrichtungen zur Spannungsüberwachung von Batteriezellen in dieser Hinsicht zu verbessern und insbesondere eine Vorrichtung zur Spannungsüberwachung von Batteriezellen anzugeben, die einfach herstellbar und zuverlässig in Ihrer Funktion ist.

Die Lösung der Aufgabe erfolgt durch eine Vorrichtung zur Spannungsüberwachung von Batteriezellen, umfassend ein Steuergerät, Spannungsabgriffe zum Abgriff der Spannungen der Batteriezellen und Messleitungen zur elektrischen Verbindung des Steuergeräts mit den Spannungsabgriffen, wobei die Messleitungen durch ein Stanzgitter gebildet sind, wobei das Stanzgitter in eine zumindest zweiteilige Halteplatte integriert ist, derart dass das Stanzgitter in, der Form des Stanzgitters entsprechenden Ausnehmungen des ersten Halteplattenteils liegt, und der zweite Halteplattenteil die Ausnehmungen bedeckt, so dass die Messleitungen in den Ausnehmungen lagefixiert sind.

Eine erfindungsgemäße Halteplatte besteht also zumindest aus zwei Halteplattenteilen, wovon im ersten Halteplattenteil ein Stanzgitter in dafür passende Ausnehmungen eingelegt ist. Durch Auslösen geeigneter Stege aus dem Stanzgitter entsteht die Topologie der Messleitungen. Durch die Auflage des zweiten Halteplattenteils sind die Messleitungen auch in der dritten Dimension (normal zur Erstreckung der Halteplatte) in ihrer Lage fixiert. Auch nach Auslösen der Stege sind die verbleibenden Messleitungen sicher in deren Ausnehmungen positioniert.

Durch den Einschluss der Messleitungen in die Ausnehmungen des ersten Halteplattenteils und Abdeckung durch den zweiten Halteplattenteil sind die Messleitungen zudem allseits gut elektrisch isoliert. Weiterbildungen der Erfindung sind in den abhängigen Ansprüchen, der Beschreibung sowie den beigefügten Zeichnungen angegeben.

Gemäß einer bevorzugten Ausgestaltung der Erfindung liegen auch die Spannungsabgriffe in den Ausnehmungen des ersten Halteplattenteils. Die Ausnehmungen sind derart geformt, dass sowohl die Messleitungen als auch die Spannungsabgriffe, insbesondere Zellverbinder, in den Ausnehmungen sicher gelagert sind. Die Zellverbinder sind mit Enden der Messleitungen form-, kraft- oder stoffschlüssig verbunden oder auch einteilig mit den Messleitungen ausgeführt.

Gemäß einer Ausführungsform werden die Spannungsabgriffe durch elastische Halteelemente in den Ausnehmungen des ersten Halteplattenteils gehalten. Insbesondere wird durch die elastischen Halteelemente die vertikale Position, normal zur Erstreckung der Halteplatte, der Spannungsabgriffe festgelegt. Durch die Elastizität ist eine begrenzte Beweglichkeit der Spannungsabgriffe sicher gestellt, beispielsweise zum Ausgleich von Fertigungstoleranzen.

Bevorzugt werden auch die Spannungsabgriffe vom zweiten Halteplattenteil zumindest teilweise bedeckt. Hierdurch wird insbesondere eine unbeabsichtigte Berührung der Spannungsabgriffe von außen verhindert.

Vorzugsweise weist der zweite Halteplattenteil Wartungsöffnungen im Bereich der Spannungsabgriffe auf. Durch die Wartungsöffnungen ist es möglich auch nach Anbringen des zweiten Halteplattenteils, während der Fertigung oder auch zur späteren Fehlerbehebung, beispielsweise durch einen Schweiß-Roboter, eine stoffschlüssige Verbindung zwischen den Spannungsabgriffen und Zellpolen herzustellen.

Vorzugsweise weist der zweite Halteplattenteil Entlüftungsöffnungen auf.

Gemäß einer bevorzugten Ausführung ist das Steuergerät in die zweiteilige Halteplatte integriert, wobei insbesondere das Steuergerät auf dem ersten Halteplattenteil aufliegt. Das Steuergerät ist dadurch ebenfalls von der zweiteiligen Halteplatte getragen und geschützt.

Bevorzugt weist der zweite Halteplattenteil eine Steuergerät-Öffnung im Bereich des Steuergeräts auf.

Besonders bevorzugt ist das Steuergerät mittels einer Steckverbindung mit steuergerätseitigen Enden der Messleitungen direkt verbunden. Das Steuergerät kann so zur Montage einfach in die Enden der Messleitungen eingesteckt werden. Die steuergerätseitigen Enden der Messleitungen liegen dazu vorzugsweise in einer gemeinsamen Abschlussebene um eine ein- oder mehrreihige Schnittstelle zu bilden.

Bevorzugt sind die steuergerätseitigen Enden der Messleitungen aus dem ersten Halteplattenteil herausgeführt und enden auf Höhe des zweiten Halteplattenteils.

Bevorzugt sind die steuergerätseitigen Enden der Messleitungen als Stecker der Steckverbindung ausgebildet und am Steuergerät Buchsen der Steckverbindung ausgebildet.

Vorzugsweise weist der zweite Halteplattenteil einen Anschlag im Bereich des Steuergeräts auf, um eine horizontale Verschiebung des Steuergeräts zu blockieren. Insbesondere während der Herstellung der Steckverbindung zwischen Steuergerät und Enden der Messleitungen kann so das Verschieben des Steuergeräts und/oder ein Wegdrücken der Enden der Messleitungen verhindert oder reduziert werden.

### Kurzbeschreibung der Zeichnungen

Die Erfindung wird im Folgenden beispielhaft unter Bezugnahme auf die Zeichnungen beschrieben.
- Fig. 1: ist eine erfindungsgemäße Vorrichtung ohne zweiten Halteplattenteil in Draufsicht.
- Fig. 2: ist eine Schnittansicht gem. B-B der Fig. 1.
- Fig. 3: ist eine Darstellung entsprechend Fig. 1 mit zweitem Halteplattenteil.
- Fig. 4: ist eine Detail-Seitenansicht der Fig. 1 im Bereich der gemeinsamen Abschlussebene A.
- Fig. 5: ist eine Detail-Seitenansicht der Fig. 1 im Bereich der gemeinsamen Abschlussebene A.
- Fig. 6: ist eine Detail-Seitenansicht der Fig. 1 im Bereich der gemeinsamen Abschlussebene A.

### Detaillierte Beschreibung der Erfindung

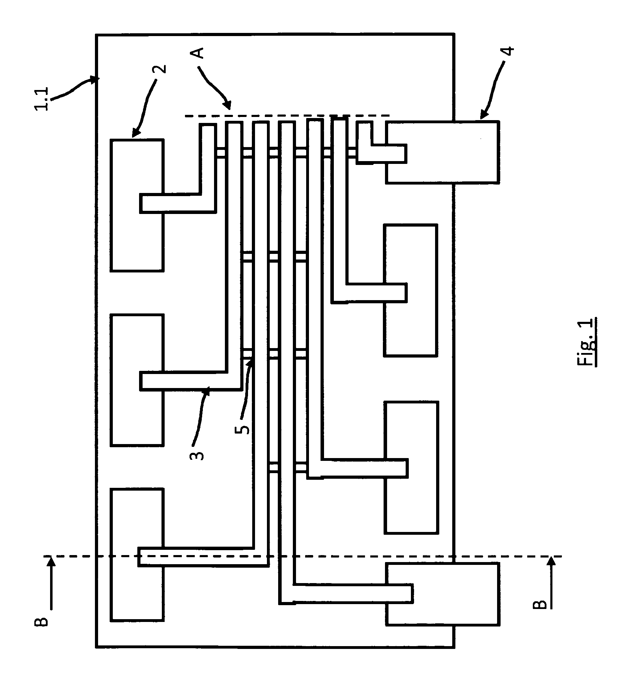

Fig. 1 zeigt eine Ansicht einer erfindungsgemäßen Vorrichtung von oben, wobei nur der erste Halteplattenteil 1.1, ohne aufgesetzten Halteplattenteil 1.2, dargestellt ist. Spannungsabgriffe 2 und Messleitungen 3 sind in hier nicht sichtbaren Ausnehmungen des ersten Halteplattenteils 1.1 eingelegt. Die Messleitungen 3 bilden zusammen mit den damit verbundenen Verbindungsstegen 5 ein Stanzgitter. Nicht gewünschte Verbindungsstege 5 werden vor der Inbetriebnahme der erfindungsgemäßen Vorrichtung entfernt. Der Spannungsabgriff des gesamten Batteriesystems erfolgt an Batteriespannungsabgriffen 4.

Jeweils ein Ende der Messleitungen 3 ist dazu ausgebildet mit einem Spannungsabgriff 2, insbesondere mit Zellverbindern oder auch den Batteriespannungsabgriffen, elektrisch leitend form- oder stoffschlüssig verbunden.

Abhängig von den eingesetzten Materialien für Zellpole und Zellverbinder kann ein Materialübergang entlang der Strecke vom Zellpol bzw. Spannungsabgriff 2 zur gemeinsamen Abschlussebene A stattfinden, beispielsweise wenn der Zellverbinder aus Aluminium und die Steckverbindung an der gemeinsamen Anschlussebene A aus Kupfer besteht. Der Materialübergang wird vorteilhaft innerhalb der Ausnehmungen des ersten Halteteils 1.1 durchgeführt, beispielsweise innerhalb der Messleitungen 3 oder in einem Anschlussstück zwischen Messleitung 3 und Spannungsabgriff 2 angeordnet ist. Die verschiedenen Materialien werden dann beispielsweise durch Schweißen, Löten, Durchsatzfügen, Schrauben, Nieten, Klemmen oder Walzplattieren gefügt.

Die steuergerätseitigen Enden 12 der Messleitungen 3 führen zu einer gemeinsamen Abschlussebene A, welche der Steckverbindung mit einem entsprechenden Gegenstück am Steuergerät 14 dient.

Insbesondere bei Ausführungen für engen Bauraum ist es denkbar eine oder mehrere weitere Halteplattenteile 1.1 in weiteren vertikalen Ebenen anzuordnen, die in jeweiligen Ausnehmungen 8.1, 8.2, 8.3 wiederum Messleitungen 3 aufnehmen. Steuergerätseitige Enden 12 von Messleitungen 3 solcher weiteren Ebenen werden ebenfalls, mit Höhenversatz, zur gemeinsamen Abschlussebene A geführt. Die Verbindungsstege 5 werden vorteilhaft genau übereinander liegend angeordnet, sodass die Verbindungsstege 5 in einem einzigen Arbeitsschritt durchtrennt werden können. Bei der Stapelung mehrerer Schichten von Halteplattenteilen 1.1 ist darauf zu achten eventuelle Entlüftungsöffnungen nicht abzudecken.

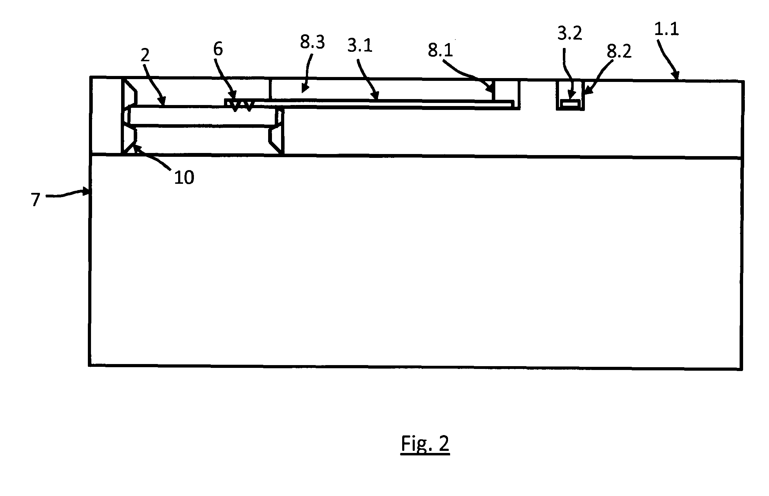

Fig. 2 zeigt einen Schnitt gem. B-B der Fig. 1. Der erste Halteplattenteil 1.1 liegt auf einem Gehäuse von Batteriezellen 7 auf. Die Batteriezellen und deren Anschluss-Terminals sind in Fig. 2 nicht näher dargestellt. Die Halteplatte 1.1, 1.2 ist bevorzugt aus elektrisch isolierendem Material gefertigt, sodass keine elektrisch isolierende Beschichtung erforderlich ist. Die Spannungsabgriffe 2 werden mittels elastischer Haltelemente 10 in Form von Stegen im ersten Halteplattenteil 1.1 gehalten. Durch diese Art der Halterung ist eine begrenzte Beweglichkeit der Spannungsabgriffe 2 im ersten Halteplattenteil 1.1 gegeben. Fertigungs- und Montagetoleranzen der Batteriezellen im Gehäuse 7 und des ersten Halteplattenteils 1.1 können somit auf einfache Weise ausgeglichen werden.

Eine erste Messleitung 3.1, die mit einem Spannungsabgriff 2 mittels einer Schweißnaht 6 verbunden ist, liegt in einer Ausnehmung 8.1, 8.3. Eine zweite Messleitung 3.2 ist in einer ihr zugedachten Ausnehmung 8.2 angeordnet. Jede Messleitung 3 sowie die Verbindungsstege 5 liegen in jeweils der Form des Stanzgitters angepassten jeweiligen Ausnehmungen 8.1, 8.2, 8.3. Die Messleitungen 3 sind durch die Halteplatte 1.1, 1.2 voneinander räumlich getrennt und daher gegen elektrischen Kurzschluss gesichert. Alternativ zur Schweißnaht 6 könnte die Verbindung beispielsweise mittels Durchsatzfügen, Löten, Schrauben oder Klemmen erfolgen.

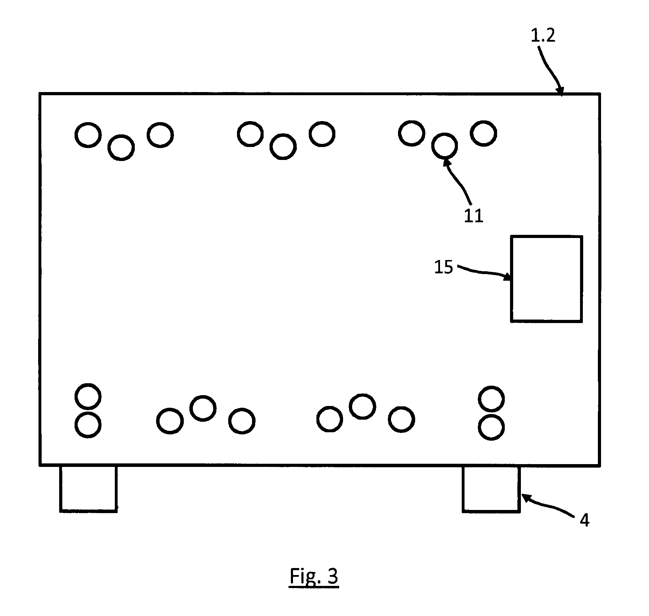

In Fig. 3 ist schließlich der zweite Halteplattenteil 1.2 dargestellt, der ebenfalls aus elektrisch isolierendem Material besteht. Der zweite Halteplattenteil 1.2 weist Wartungsöffnungen 11 auf, durch die ein Schweißroboter die stoffschlüssige Verbindung zwischen Zellpolen und Spannungsabgriffen 2, sowie zwischen Spannungsabgriffen 2 und Messleitungen 3 herstellen kann. Weiters ist im zweiten Halteplattenteil 1.2 eine Steuergerätöffnung 15 vorgesehen, durch welche die Montage bzw. Wartung des Steuergeräts 14 möglich ist.

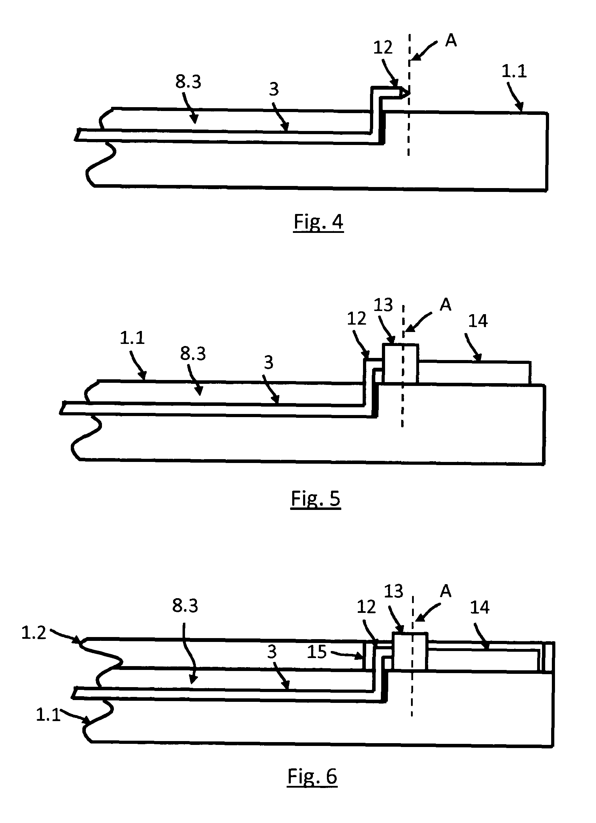

Die Fig. 4, Fig. 5 und Fig. 6 zeigen jeweils Schnitt-Detailansichten der steuergerätseitigen Enden 12 der Messleitungen 3 im Bereich der gemeinsamen Abschlussebene A. Dabei ist in Fig. 4 nur der erste Halteplattenteil 1.1 ohne Steuergerät 14, in Fig. 5 der erste Halteplattenteil 1.1 mit Steuergerät 14 und in Fig. 6 zusätzlich der aufgesetzte zweite Halteplattenteil 1.2 dargestellt. Das freie Ende der Messleitungen 3 weist im Bereich der gemeinsamen Anschlussebene A jeweils einen Versatz auf. Dieses steuergerätseitige Ende 12 der Messleitungen 3 ist dafür vorbereitet, in Buchsen 13 einer Steckverbindung am Steuergerät 14 geführt zu werden. Um einen sicheren elektrischen Kontakt zu gewährleisten, können die steuergerätseitigen Enden 12 der Messleitungen 3 eine Oberflächenbeschichtung aufweisen (z.B. Nickel, Messing).

Der zweite Halteplattenteil 1.2 weist, wie in Fig. 6 zu sehen, einen Anschlag auf, der durch den Rand der Steuergerät-Öffnung 15 gebildet wird. Durch den Anschlag wird verhindert, dass sich die steuergerätseitigen Enden 12 der Messleitungen 3 beim Fügen mit den Buchsen 13 der Steckverbindung zu stark verformen.

Das Steuergerät 14 ist mit dem ersten Halteplattenteil 1.1 in geeigneter Weise mechanisch verbunden, beispielsweise durch Verclipsen, Schrauben oder Klemmen.

### Bezugszeichenliste

- 1.1: erster Halteplattenteil
- 1.2: zweiter Halteplattenteil
- 2: Spannungsabgriff
- 3, 3.1, 3.2: Messleitung
- 4: Batteriespannungsabgriff
- 5: Verbindungsstege
- 6: Schweißnaht
- 7: Gehäuse der Batteriezellen
- 8.1, 8.2, 8.3: Ausnehmungen
- 10: elastische Halteelemente
- 11: Wartungsöffnungen
- 12: steuergerätseitige Enden der Messleitungen
- 13: Buchsen der Steckverbindung
- 14: Steuergerät
- 15: Steuergerät-Öffnung

- A: gemeinsame Abschlussebene

## Patentansprüche

1. Vorrichtung zur Spannungsüberwachung von Batteriezellen, umfassend ein Steuergerät (14), Spannungsabgriffe (2) zum Abgriff der Spannungen der Batteriezellen und Messleitungen (3) zur elektrischen Verbindung des Steuergeräts (14) mit den Spannungsabgriffen (2), wobei die Messleitungen (3) durch ein Stanzgitter gebildet sind,
**dadurch gekennzeichnet, dass** das Stanzgitter in eine zumindest zweiteilige Halteplatte (1.1, 1.2) integriert ist, derart dass das Stanzgitter in der Form des Stanzgitters entsprechenden Ausnehmungen (8.1, 8.2, 8.3) des ersten Halteplattenteils (1.1) liegt, und der zweite Halteplattenteil (1.2) die Ausnehmungen (8.1, 8.2, 8.3) bedeckt, so dass die Messleitungen (3) in den Ausnehmungen (8.1, 8.2, 8.3) lagefixiert sind.

2. Vorrichtung nach Anspruch 1,
**dadurch gekennzeichnet, dass** auch die Spannungsabgriffe (2) in den Ausnehmungen (8.1, 8.2, 8.3) des ersten Halteplattenteils (1.1) liegen.

3. Vorrichtung nach Anspruch 2,
**dadurch gekennzeichnet, dass** die Spannungsabgriffe (2) durch elastische Halteelemente (10) in den Ausnehmungen (8.1, 8.2, 8.3) des ersten Halteplattenteils (1.1) gehalten werden.

4. Vorrichtung nach zumindest einem der vorhergehenden Ansprüche,
**dadurch gekennzeichnet , dass** auch die Spannungsabgriffe (2) vom zweiten Halteplattenteil (1.2) zumindest teilweise bedeckt werden.

5. Vorrichtung nach zumindest einem der vorhergehenden Ansprüche,
**dadurch gekennzeichnet, dass** der zweite Halteplattenteil (1.2) Wartungsöffnungen (11) im Bereich der Spannungsabgriffe (2) aufweist.

6. Vorrichtung nach zumindest einem der vorhergehenden Ansprüche,
**dadurch gekennzeichnet , dass** das Steuergerät (14) in die zweiteilige Halteplatte (1.1, 1.2) integriert ist, wobei insbesondere das Steuergerät (14) auf dem ersten Halteplattenteil (1.1) aufliegt.

7. Vorrichtung nach zumindest einem der vorhergehenden Ansprüche,
**dadurch gekennzeichnet , dass** der zweite Halteplattenteil (1.2) eine Steuergerät-Öffnung (15) im Bereich des Steuergeräts (14) aufweist.

8. Vorrichtung nach zumindest einem der vorhergehenden Ansprüche,
**dadurch gekennzeichnet , dass** das Steuergerät (14) mittels einer Steckverbindung mit steuergerätseitigen Enden (12) der Messleitungen (3) direkt verbunden ist.

9. Vorrichtung nach zumindest einem der vorhergehenden Ansprüche,
**dadurch gekennzeichnet , dass** die steuergerätseitigen Enden (12) der Messleitungen (3) aus dem ersten Halteplattenteil (1.1) herausgeführt sind und auf Höhe des zweiten Halteplattenteils (1.2) enden.

10. Vorrichtung nach zumindest einem der vorhergehenden Ansprüche,
**dadurch gekennzeichnet , dass** die steuergerätseitigen Enden (12) der Messleitungen (3) als Stecker der Steckverbindung ausgebildet sind und am Steuergerät (14) Buchsen (13) der Steckverbindung ausgebildet sind.

11. Vorrichtung nach zumindest einem der vorhergehenden Ansprüche,
**dadurch gekennzeichnet , dass** der zweite Halteplattenteil (1.2) einen Anschlag im Bereich des Steuergeräts (14) aufweist, um eine horizontale Verschiebung des Steuergeräts (14) zu blockieren.

## Claims

1. Device for monitoring the voltage of battery cells, which device comprises a control device (14), voltage taps (2) for tapping the voltages of battery cells and measuring lines (3) for electrically connecting the control device (14) to the voltage taps (2), wherein the measuring lines (3) are embodied by a stamped-out circuit, **characterized in that** the stamped-out circuit is integrated in an at least two-part holding plate (1.1, 1.2) in such a manner that the stamped-out circuit lies in cut-outs (8.1, 8.2, 8.3) of the first holding plate part (1.1), which cut-outs correspond to the shape of the stamped-out circuit, and the second holding plate part (1.2) covers the cut-outs (8.1, 8.2, 8.3) so that the measuring lines (3) are fixed in position in the cut-outs (8.1, 8.2, 8.3).

2. Device according to Claim 1, **characterized in that** the voltage taps (2) also lie in the cut-outs (8.1, 8.2, 8.3) of the first holding plate part (1.1).

3. Device according to Claim 2, **characterized in that** the voltage taps (2) are held in the cut-outs (8.1, 8.2, 8.3) of the first holding plate part (1.1) by means of elastic holding elements (10).

4. Device according to at least one of the preceding claims, **characterized in that** the voltage taps (2) are also covered at least partially by the second holding plate part (1.2).

5. Device according to at least one of the preceding claims, **characterized in that** the second holding plate part (1.2) comprises maintenance orifices (11) in the region of the voltage taps (2).

6. Device according to at least one of the preceding claims, **characterized in that** the control device (14) is integrated in the two-part holding plate (1.1, 1.2), wherein in particular the control device (14) lies on the first holding plate part (1.1).

7. Device according to at least one of the preceding claims, **characterized in that** the second holding plate part (1.2) comprises a control device orifice (15) in the region of the control device (14).

8. Device according to at least one of the preceding claims, **characterized in that** the control device (14) is directly connected by means of a plug connector to the control device-side ends (12) of the measuring lines (3).

9. Device according to at least one of the preceding claims, **characterized in that** the control device-side ends (12) of the measuring lines (3) are routed out of the first holding plate part (1.1) and terminate at the height of the second holding plate part (1.2).

10. Device according to at least one of the preceding claims, **characterized in that** the control device-side ends (12) of the measuring lines (3) are embodied as male connectors of the plug connection and female connectors (13) of the plug connection are embodied on the control device (14).

11. Device according to at least one of the preceding claims, **characterized in that** the second holding plate part (1.2) comprises a stop in the region of the control device (14) in order to block a horizontal displacement of the control device (14).

## Revendications

1. Dispositif pour la surveillance de la tension de cellules de batterie, comprenant un appareil de commande (14), des prises de tension (2) pour la prise des tensions des cellules de batterie, et des lignes de mesure (3) pour la connexion électrique de l'appareil de commande (14) avec les prises de tension (2), les lignes de mesure (3) étant formées par une grille estampée,
**caractérisé en ce que** la grille estampée est intégrée dans une plaque de support (1.1, 1.2) au moins en deux parties de manière à ce que la grille estampée se situe dans des évidements (8.1, 8.2, 8.3) correspondant à la forme de la grille estampée de la première partie de plaque de support (1.1) et que la deuxième partie de plaque de support (1.2) recouvre les évidements (8.1, 8.2, 8.3) de manière à ce que les lignes de mesure (3) soient fixées en position dans les évidements (8.1, 8.2, 8.3).

2. Dispositif selon la revendication 1,
**caractérisé en ce que** les prises de tension (2) se situent également dans les évidements (8.1, 8.2, 8.3) de la première partie de plaque de support (1.1).

3. Dispositif selon la revendication 2,
**caractérisé en ce que** les prises de tension (2) sont maintenues par des éléments de retenue élastiques (10) dans les évidements (8.1, 8.2, 8.3) de la première partie de plaque de support (1.1).

4. Dispositif selon l'une au moins des revendications précédentes,
**caractérisé en ce que** les prises de tension (2) sont également recouvertes, au moins partiellement, par la deuxième partie de plaque de support (1.2).

5. Dispositif selon l'une au moins des revendications précédentes,
**caractérisé en ce que** la deuxième partie de plaque de support (1.2) présente des ouvertures de service (11) dans la zone des prises de tension (2).

6. Dispositif selon l'une au moins des revendications précédentes,
**caractérisé en ce que** l'appareil de commande (14) est intégré dans la plaque de support (1.1, 1.2) en deux parties, l'appareil de commande (14) reposant en particulier sur la première partie de plaque de support (1.1).

7. Dispositif selon l'une au moins des revendications précédentes,
**caractérisé en ce que** la deuxième partie de plaque de support (1.2) présente une ouverture d'appareil de commande (15) dans la zone de l'appareil de commande (14).

8. Dispositif selon l'une au moins des revendications précédentes,
**caractérisé en ce que** l'appareil de commande (14) est directement relié, à l'aide d'un raccord enfichable, à des extrémités (12) côté appareil de commande des lignes de mesure (3).

9. Dispositif selon l'une au moins des revendications précédentes,
**caractérisé en ce que** les extrémités (12) côté appareil de commande des lignes de mesure (3) sortent de la première partie de plaque de support (1.1) et se terminent à la hauteur de la deuxième partie de plaque de support (1.2).

10. Dispositif selon l'une au moins des revendications précédentes,
**caractérisé en ce que** les extrémités (12) côté appareil de commande des lignes de mesure (3) sont réalisées en tant que prises mâles du raccord enfichable et **en ce que** des prises femelles (13) du raccord enfichable sont réalisées sur l'appareil de commande (14).

11. Dispositif selon l'une au moins des revendications précédentes,
**caractérisé en ce que** la deuxième partie de plaque de support (1.2) présente une butée dans la zone de l'appareil de commande (14) afin de bloquer un décalage horizontal de l'appareil de commande (14).
